# EUROPEAN PATENT SPECIFICATION

(11) **EP 4 395 168 B1**
(45) Date of publication and mention of the grant of the patent: **02.09.2026**
(21) Application number: 23866669.7
(22) Date of filing: 13.06.2023
(51) Int. Cl.: G03F 7/20, H10N 60/01, H10N 69/00, H03F 7/00

(54) **CHIP PREPARATION METHOD AND SYSTEM**
CHIPHERSTELLUNGSVERFAHREN UND -SYSTEM
PROCÉDÉ ET SYSTÈME DE PRÉPARATION DE PUCE

(30) Priority: 21.10.2022 CN 202211295833
(43) Date of publication of application: 03.07.2024
(73) Proprietor: Tencent Technology (Shenzhen) Company Limited, Shenzhen, Guangdong 518057 (CN)
(72) Inventor: HU, Jingjing, Guangdong 518057 (CN); DAI, Maochun, Guangdong 518057 (CN); AN, Shuoming, Guangdong 518057 (CN); ZHANG, Wenlong, Guangdong 518057 (CN); LI, Dengfeng, Guangdong 518057 (CN); ZHANG, Shengyu, Guangdong 518057 (CN)
(74) Representative: Novagraaf International SA
(86) International application number: PCT/CN2023/099811
(87) International publication number: WO 2024/082657

(56) References cited:
- EP-A1- 4 395 169
- WO-A1-2021/214383
- WO-A1-2021/247878
- WO-A1-2022/179418
- CN-A- 108 259 014
- CN-A- 112 885 952
- CN-A- 114 122 247
- CN-A- 114 665 836
- CN-A- 115 047 723
- CN-U- 215 731 778
- URADE Y ET AL: "Impedance-matched Josephson parametric amplifier using open stubs as shunt capacitance - APS March Meeting 2020 - Abstract", 2 December 2021 (2021-12-02), pages 1 - 1, XP093227525, Retrieved from the Internet <URL:https://web.archive.org/web/20211202104839/https://meetings.aps.org/Meeting/MAR20/Session/J07.5>
- URADE Y ET AL: "Impedance-matched Josephson parametric amplifier using open stubs as shunt capacitance - APS March Meeting 2020 - Slides", 3 March 2020 (2020-03-03), pages 1 - 1, XP093227590, Retrieved from the Internet <URL:https://absuploads.aps.org/presentation.cfm?pid=16984>

## Description

### FIELD OF THE TECHNOLOGY

This application relates to the field of micro/nanofabrication technologies, and in particular, to a chip preparation method and system, and a chip.

### BACKGROUND OF THE DISCLOSURE

An impedance matching Josephson parametric amplifier is an important component of a superconducting quantum computing measurement circuit, and may satisfy a multi-bit measurement task.

In related technologies, because the impedance matching Josephson parametric amplifier requires high processing accuracy of a component, especially a Josephson junction, the impedance matching Josephson parametric amplifier is generally prepared by using an electron beam exposure processing process.

However, the electron beam exposure processing process needs to prepare an additional metal layer as an electron beam overlay mark. This introduces an additional exposure-coating-lifting off process, and causes a complex preparation process of the impedance matching Josephson parametric amplifier. In this case, preparation efficiency is affected.

An article entitled "Impedance-matched Josephson parametric amplifier using open stubs as shunt capacitance", Urade Y et al, APS March Meeting 2020, describes that open stubs (open-circuited transmission lines connected at one end) can be used as shunt capacitances for Josephson parametric amplifier resonators.

EP 4395169 A1 provides a determination method and apparatus for a superconducting impedance transformation parametric amplifier, a superconducting impedance transformation parametric amplifier, an electronic device, a computer program product and a computer-readable storage medium. The method comprises: based on a wavelength parameter, a gain parameter and a bandwidth parameter, calculating an impedance value of an impedance transformation line of a superconducting impedance transformation parametric amplifier and a capacitance value of the amplifier; based on the impedance value of the impedance transformation line, calculating a linewidth dimension of a coplanar waveguide of the superconducting impedance transformation parametric amplifier; based on the impedance value of the impedance transformation line and the capacitance value of the amplifier, calculating a stub dimension of the superconducting impedance transformation parametric amplifier; and based on the linewidth dimension and the stub dimension, determining structural parameters of the superconducting impedance transformation parametric amplifier.

CN 114665836A provides an impedance matching Josephson parametric amplifier based on a double-section quarter-wavelength conversion line, which includes an input/output port, an impedance matching transmission line, a nonlinear LC resonator and a direct current bias line, and the impedance matching transmission line is composed of two sections of quarter-wavelength transmission lines and adopts a coplanar waveguide transmission line form; the width of the coplanar waveguide center conductor and the width of the gap are adjusted according to the required impedance value.

WO 2022/179418 A1 provides a superconducting circuit preparation method. The preparation method includes: determining a first junction area located between a first electric element and a second electric element on a substrate, and a second junction area located between a first conductive plate and a second conductive plate that are preformed; forming a Josephson junction in the second junction area, a first superconducting layer and a second superconducting layer of the Josephson junction being electrically connected to the first conductive plate and the second conductive plate in a one-to-one correspondence manner; connecting the first conductive plate and the second conductive plate to a detection circuit to measure an electrical parameter of the Josephson junction and determine whether the electrical parameter is within a target parameter range; if yes, cutting and separating the Josephson junction from the first conductive plate and the second conductive plate, and moving the Josephson junction to the first junction area; and forming a first connection structure for connecting the first superconducting layer and the first electric element, and a second connection structure for connecting the second superconducting layer and the second electric element.

### SUMMARY

Embodiments of this application provide a chip preparation method, system, and a chip. This may improve performance of a chip product. A technical solution is as follows.

According to a first aspect, a chip preparation method is provided, and the method includes the following steps:
preparing, on a substrate by using a laser direct writing exposure manner, a first underlying circuit of an impedance matching Josephson parametric amplifier, and preparing, on the substrate, a second underlying circuit of a Josephson junction for testing, to obtain a first chip product;
generating, on the first chip product by using the laser direct writing exposure manner, a photoresist structure for preparing the Josephson junction.
cutting the first underlying circuit and the second underlying circuit on the first chip product, to obtain a second chip product including the second underlying circuit and a third chip product including the first underlying circuit;
trial producing a Josephson junction sample on the second chip product using the photoresist structure on the second underlying circuit, to determine an oxidation condition for preparing an oxide layer in the Josephson junction;
preparing, according to the oxidation condition, the Josephson junction on the third chip product using the photoresist structure on the first underlying circuit, to obtain a fourth chip product; and
obtaining, based on the fourth chip product, a target chip product including the impedance matching Josephson parametric amplifier.

According to another aspect, a chip preparation system is provided, and the system includes: a resist coating machine, a photo engraving machine, an evaporation machine, an etching machine, an oxidation chamber, a cleaning machine, and a cutting machine;
the resist coating machine, the photo engraving machine, the evaporation machine, the etching machine, and the cleaning machine being configured to: prepare, by using a laser direct writing exposure manner, a first underlying circuit of an impedance matching Josephson parametric amplifier on a substrate, and prepare a second underlying circuit of a Josephson junction for testing on the substrate, to obtain a first chip product;
the resist coating machine and the photo engraving machine being configured to: generate, on the first chip product by using a laser direct writing exposure manner, a photoresist structure for preparing the Josephson junction;
the cutting machine being configured to cut the first underlying circuit and the second underlying circuit on the first chip product, to obtain a second chip product including the second underlying circuit and a third chip product including the first underlying circuit;
the evaporation machine and the oxidation chamber being configured to trial produce a Josephson junction sample on the second chip product using the photoresist structure on the second underlying circuit, to determine an oxidation condition for preparing an oxide layer in the Josephson junction;
the evaporation machine and the oxidation chamber being further configured to: prepare, according to the oxidation condition, the Josephson junction on the third chip product using the photoresist structure on the first underlying circuit, to obtain a fourth chip product; and
the resist coating machine, the photo engraving machine, the evaporation machine, the etching machine, and the cleaning machine being further configured to: obtain, based on the fourth chip product, a target chip product including the impedance matching Josephson parametric amplifier.
In a possible implementation, the first underlying circuit includes a capacitance part of a non-linear inductor-capacitor (LC) resonator of the impedance matching Josephson parametric amplifier, and
the capacitance part is a planar stub line of a coplanar waveguide structure.

In a possible implementation, the resist coating machine, the photolithography machine, the evaporation machine, the etching machine, and the cleaning machine are configured to: prepare an air bridge at a root of the planar stub line on the fourth chip product; and prepare the fourth chip product to a target chip product.

In a possible implementation, the process of preparing the air bridge at the root of the planar stub line on the fourth chip product, to obtain the target chip product includes the following steps:
the resist coating machine, being configured to coat a first photoresist layer on the fourth chip product;
the photolithography machine, being configured to: expose and develop a bridge pier area of the air bridge at a position of the first photoresist layer corresponding to the root of the planar stub line; and
reflow the first photoresist layer, to make the remaining photoresist in the first photoresist layer arched;
the evaporation machine, being configured to deposit a bridge material of the air bridge on the arched first photoresist layer;
the resist coating machine, being configured to coat a second photoresist layer on the bridge material;
the photolithography machine, being configured to expose and develop an area outside a bridge of the air bridge in the second photoresist layer;
the etching machine, being configured to remove the bridge material outside the bridge of the air bridge by using an etching method; and
the cleaning machine, being configured to clean a photoresist on the fourth chip product, to obtain the target chip product.

In a possible implementation, under the oxidation condition, a resistance value of the Josephson junction sample is less than a designed resistance value of the Josephson junction sample, and the resistance value difference between the resistance value of the Josephson junction sample and the designed resistance value of the Josephson junction sample matches a resistance value increment of the air bridge to the Josephson junction.

In a possible implementation, the evaporation machine is configured to deposit an underlying circuit material on the substrate.

The resist coating machine is configured to coat a third photoresist layer on the underlying circuit material.

The photolithography machine is configured to expose and develop, in the third photoresist layer by using the laser direct writing exposure manner, etching areas corresponding to the first underlying circuit and the second underlying circuit.

The etching machine is configured to etch the third photoresist layer, to remove the underlying circuit material in the etching areas.

The cleaning machine is configured to clean off photoresist from the substrate, to obtain the first chip product.

In a possible implementation, the photolithography machine is configured to: define, in the third photoresist layer by using a laser direct writing manner, circuit patterns of the first underlying circuit and the second underlying circuit; place the substrate in a developer for development, to develop the etching areas corresponding to the first underlying circuit and the second underlying circuit.

In a possible implementation, the first underlying circuit includes an impedance transformer of the impedance matching Josephson parametric amplifier.

A compensation bias exists between a line width of the impedance transformer in a layout and a designed line width of the impedance transformer, and the compensation bias is determined based on an etching bias of an etching processing on the third photoresist layer.

In a possible implementation, the second underlying circuit includes a Josephson junction sample array. The Josephson junction sample array includes port circuits of at least two Josephson junction samples, and each port circuit corresponds to a group of photoresist structures.

The evaporation machine and the oxidation chamber are configured to: prepare, under a first oxidation condition using the photoresist structure on a first port circuit, the Josephson junction sample corresponding to the first port circuit, where the first port circuit is a port circuit on which a Josephson junction sample has not been prepared in the port circuits of the at least two Josephson junction samples.

In a case that a first resistance value satisfies a design requirement, the first oxidation condition is determined as the oxidation condition for preparing the oxide layer in the Josephson junction, where the first resistance value is obtained, based on the first port circuit, by measuring the Josephson junction sample corresponding to the first port circuit.

In a possible implementation, the oxidation chamber is further configured to:

update the first oxidation condition and the first port circuit to perform the test in a case that the first resistance value does not satisfy the design requirement.

In a possible implementation, the photoresist structure is a dolan bridge structure.

The evaporation machine is configured to obliquely evaporate, using the photoresist structure on the first port circuit, a first superconducting layer of the Josephson junction sample corresponding to the first port circuit.

The oxidation chamber is configured to oxidize the first superconducting layer under the first oxidation condition, to obtain an oxide insulation layer on a surface of the first superconducting layer.

The evaporation machine is configured to: vertically evaporate, using the photoresist structure on the first port circuit, a second superconducting layer of the Josephson junction sample that corresponds to the first port circuit, to obtain the Josephson junction sample corresponding to the first port circuit.

In a possible implementation, the first oxidation condition includes at least one piece of the following information:
an air flow rate, pressure, and oxidation time of oxygen.

A beneficial effect brought by the technical solution provided by embodiments of this application at least includes:

In a process of preparing the impedance matching Josephson parametric amplifier, the Josephson junction and other underlying circuits are prepared by using a laser direct writing manner. In addition, to ensure the preparation accuracy of the Josephson junction, a trial preparation process of the Josephson junction sample is introduced, to obtain the oxidation condition for formal preparation of the Josephson junction. This ensures preparation accuracy of the impedance matching Josephson parametric amplifier, reduces complexity of a preparation process of the impedance matching Josephson parametric amplifier, and increases preparation efficiency of the impedance matching Josephson parametric amplifier.

### BRIEF DESCRIPTION OF THE DRAWINGS

FIG. 1 is a schematic diagram of a structure of an impedance matching Josephson parametric amplifier involved in this application.
FIG. 2 is a method flowchart of a chip preparation method according to an exemplary embodiment of this application.
FIG. 3 is a method flowchart of a chip preparation method according to an exemplary embodiment of this application.
FIG. 4 is a schematic diagram of a photoresist structure involved in the embodiment shown in FIG. 3.
FIG. 5 is a schematic diagram of preparing a Josephson junction by using a dolan bridge involved in the embodiment shown in FIG. 3.
FIG. 6 is a schematic diagram of a layout design involved in this application.
FIG. 7 is a schematic flowchart of preparing an impedance transformation Josephson parametric amplifier involved in this application.
FIG. 8 is a schematic diagram of a product form change in a process of preparing an impedance transformation Josephson parametric amplifier involved in an embodiment of this application.
FIG. 9 is a schematic diagram of a structure of a chip according to an exemplary embodiment of this application.
FIG. 10 is a schematic diagram of a chip preparation system according to an exemplary embodiment of this application.
FIG. 11 is a schematic diagram of a solution application scenario according to an embodiment of this application.

### DESCRIPTION OF EMBODIMENTS

Lift off: After a substrate is coated with a photoresist, exposed, and developed, a photoresist film having a pattern is used as a mask. A tape deposits a required material such as metal through evaporation. Then, while the photoresist is removed, a non-required material on a resist film is lifted off. Last, only a material structure of an initially etched pattern is left on the substrate.

Undercut (undercut): In a bi-layer resist process, the photoresist of an upper resist is exposed and developed to form a window; and an underlying resist continues to be etched in a developer, and expands laterally, to form a structure that is narrow at top and wide at bottom.

Resist remover: An organic solvent that may remove a residual photoresist that has not reacted with light after a sample is exposed and developed.

Prebake: One basic step of a photo engraving process, is also referred to as soft bake. To be specific, at certain temperature, a solvent in the photoresist film slowly and fully escapes, so that the photoresist film is dried.

Bridge pier: An area on an underlying circuit structure that is set aside for an air bridge to be contact with an underlying circuit.

Exposure and development: A nanofabrication technology, mainly involves ultraviolet photo engraving. To be specific, the photoresist is coated on a surface of a substrate sample, and ultraviolet light is irradiated through the mask to a surface of the substrate, to change a property of a part of the photoresist that is irradiated by the light by using a photochemical reaction. Then, an area reacting with the light is dissolved into a specific solution. This achieves a purpose of creating a specific pattern on the substrate.

Etching: A microprocessing process, uses a dry (other) method and a wet (liquid) method to etch metal or other materials to form a required structure.

A Josephson parametric amplifier is an important component of a superconducting quantum computing measurement circuit, and is mainly configured to enhance an intensity of a read signal in a qubit measurement process, and effectively suppress read noise at the same time. This may achieve signal amplification at several photon levels at a mK temperature. The Josephson parametric amplifier is classified into a conventional narrowband parametric amplifier and an impedance matching Josephson parametric amplifier. Compared with the narrowband parametric amplifier, an impedance transformer is added at an input end of the impedance matching Josephson parametric amplifier, to achieve a higher gain bandwidth by sacrificing a gain peak, to satisfy a multi-bit measurement task.

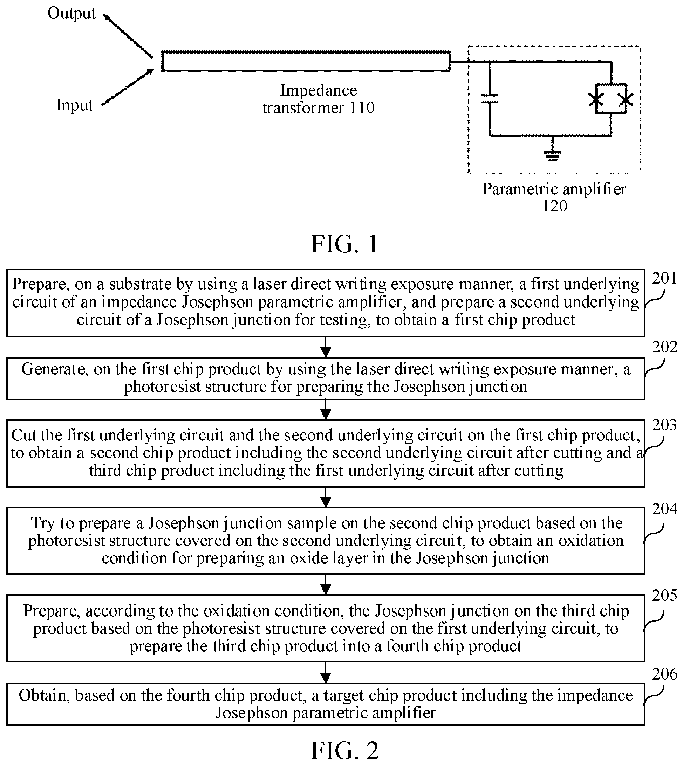

FIG. 1 is a schematic diagram of a structure of an impedance matching Josephson parametric amplifier involved in this application. As shown in FIG. 1, a main structure of the impedance matching Josephson parametric amplifier mainly includes an impedance transformer 110 and a parametric amplifier 120. The parametric amplifier 120 includes a non-linear LC resonator (including a planar capacitor and a non-linear inductor Josephson junction) and a pump driver.

A Josephson junction is a superconductor-insulator-superconductor structure in which superconducting electrons may pass through an insulator film from one side to another side by a tunneling effect. In the related art, a junction shape is generally exposed by using an electron beam exposure machine, and a methyl methacrylate (MMA) electron beam photoresist and a poly methyl methacrylate (PMMA) electron beam photoresist need to be used. The MMA is an underlying resist with a thickness ranging from 400nm to 800nm, and the PMMA is an upper resist with a thickness ranging from 300nm to 500nm. In the related art, the impedance transformer of a superconducting impedance transformation parametric amplifier uses a structure in which a quarter-wavelength waveguide and a half-wavelength waveguide are connected in series. This structure is sensitive to a processing parameter and has a requirement on a line width of a coplanar waveguide (Coplanar Waveguide, CPW). In the related art, most capacitance structures of a quantum parametric amplifier use a parallel-plate dielectric capacitor, that is, a structure formed by an insulation layer between two superconducting plates. Capacitance density of this structure is high, and can provide required capacitance in a small area.

In the related art, Josephson junction preparation has the following disadvantages:

First, after a specific pattern layer is formed through exposure, in a case that a metal layer is deposited, it is easy to form a residue on a side wall of the pattern layer and adhere to a metal pattern on a substrate. As a result, it is difficult to lift off the residue, and a finally obtained junction shape is defective.

Second, for most electron beam exposure, an additional metal layer needs to be prepared as an electron beam overlay mark. According to the principle of electron beam exposure, an atomic number a material of the metal layer needs to be greatly different from that of a metal layer on the substrate, so that the overlay mark can be identified and distinguished under a scanning electron microscope. This requirement forces to introduce one more step of an exposure-coating-lifting off process, which increases process complexity.

Therefore, the subsequent embodiments of this application provide a chip preparation method for an impedance matching Josephson parametric amplifier. The method may ensure preparation accuracy of the Josephson junction, reduce the process complexity, and increases preparation efficiency of the impedance matching Josephson parametric amplifier.

FIG. 2 is a method flowchart of a chip preparation method according to an exemplary embodiment of this application. As shown in FIG. 2, the method includes the following steps:

Step 201: Prepare, on a substrate by using a laser direct writing exposure manner, a first underlying circuit of an impedance Josephson parametric amplifier, and prepare, on the substrate, a second underlying circuit of a Josephson junction for testing, to obtain a first chip product.

In this embodiment of this application, first, the first underlying circuit and the second underlying circuit of the impedance Josephson parametric amplifier are prepared simultaneously on a same substrate. The first underlying circuit is an underlying circuit that does not include a Josephson junction, and the second underlying circuit is an underlying circuit of the Josephson junction for testing. In some embodiments, the second underlying circuit does not include the Josephson junction for testing. For example, the second underlying circuit includes a port circuit of the Josephson junction for testing.

In some embodiments, the second underlying circuit of the Josephson junction for testing refers to testing the second underlying circuit to determine a preparation condition of a formal circuit. That is, the second underlying circuit is a tested circuit. In a preparation process of the second underlying circuit, a condition of circuit preparation is determined by testing. Therefore, in formal circuit preparation, the condition determined by testing is used for preparation.

Step 202: Generate, on the first chip product by using the laser direct writing exposure manner, a photoresist structure for preparing the Josephson junction.

In this embodiment of this application, after the first underlying circuit and the second underlying circuit are prepared, the photoresist structure for preparing the Josephson junction is generated at a corresponding position on the substrate at which the Josephson junction needs to be prepared, for example, a dolan bridge structure for preparing the Josephson junction is generated.

In the solution shown in this embodiment of this application, a circuit for testing of a formal product is prepared simultaneously on the same substrate, so that a preparation environment of a formal Josephson junction product and a preparation environment of a Josephson junction sample for testing may be kept consistent, including but not limited to that conditions of a thickness of the photoresist, an exposure intensity, development time, junction area size design, and a coating condition may be kept consistent when the formal Josephson junction product and the Josephson junction sample are prepared. Therefore, an oxidation condition of the formal Josephson junction product can be accurately tested.

Step 203: Cut the first underlying circuit and the second underlying circuit on the first chip product, to obtain a second chip product including the second underlying circuit and a third chip product including the first underlying circuit.

With a goal of separating the first underlying circuit and the second underlying circuit, the first chip product is divided, to obtain the first underlying circuit and the second underlying circuit that are separated from each other after cutting. A chip part in which the second underlying circuit is located is used as the second chip product, and a chip part in which the first underlying circuit is located is used as the third chip product.

In some embodiments, the first underlying circuit and the second underlying circuit on the first chip product are cut, to obtain the second chip product including the second underlying circuit and the third chip product including the first underlying circuit.

In this embodiment of this application, after the photoresist structure for preparing the Josephson junction is generated, the second underlying circuit may be cut from the substrate, to obtain the third chip product corresponding to a formal product and the second chip product for testing. That the second underlying circuit is cut from the substrate refers to cutting the first chip product. The first chip product is cut into the second chip product and the third chip product based on a standard that the first underlying circuit and the second underlying circuit are cut into different cutting parts. The first underlying circuit is on the third chip product, and the second underlying circuit is on the second chip product. To be specific, on the first chip product, the first underlying circuit is in an area A, the second underlying circuit is in an area B, and the first chip product is cut based on a requirement of cutting the area A and the area B, to obtain the third chip product including the first underlying circuit and the second chip product including the second underlying circuit.

Step 204: Trial produce a Josephson junction sample on the second chip product using the photoresist structure on the second underlying circuit, to determine an oxidation condition for preparing an oxide layer in the Josephson junction.

Because the second chip product and the third chip product are prepared simultaneously on the same substrate, the conditions of the thickness of the photoresist, the exposure intensity, the development time, the junction area size design, and the coating condition of the second chip product and the third chip product are consistent. In this way, when a Josephson junction sample is tried to be prepared on the second chip product, if the trial Josephson junction sample satisfies a design requirement of the Josephson junction of the impedance Josephson parametric amplifier, when the oxidation condition in this case is used in preparation of the formal product, an oxide layer that satisfies the design requirement can also be obtained. To be specific, an oxidation condition corresponding to the trial Josephson junction sample that satisfies the design requirement is used as an oxidation condition of a Josephson junction in the formal product that is prepared subsequently. This ensures preparation accuracy of the Josephson junction in the subsequent formal product.

Step 205: Prepare, according to the oxidation condition, the Josephson junction on the third chip product using the photoresist structure on the first underlying circuit; to obtain a fourth chip product.

A manner of preparing the Josephson junction on the third chip product using the photoresist structure corresponding to the first underlying circuit is similar to a manner of the trial Josephson junction sample. That is, the oxide layer of the Josephson junction in the formal product is prepared by using the oxidation condition corresponding to the trial Josephson junction sample that satisfies the design requirement. After the oxidation condition is determined, the Josephson junction is prepared on the third chip product according to the oxidation condition, to prepare the third chip product that originally does not include the Josephson junction into the fourth chip product that includes the Josephson junction.

Step 206: Obtain, based on the fourth chip product, a target chip product including the impedance Josephson parametric amplifier.

In conclusion, according to the solution shown in this embodiment of this application, in a process of preparing the impedance Josephson parametric amplifier, the Josephson junction and other underlying circuits are prepared by using a laser direct writing manner. In addition, to ensure the preparation accuracy of the Josephson junction, a trial preparation process of the Josephson junction sample is introduced, to obtain the oxidation condition for formal preparation of the Josephson junction. This ensures preparation accuracy of the impedance Josephson parametric amplifier, reduces complexity of a preparation process of the impedance Josephson parametric amplifier, and increases preparation efficiency of the impedance Josephson parametric amplifier.

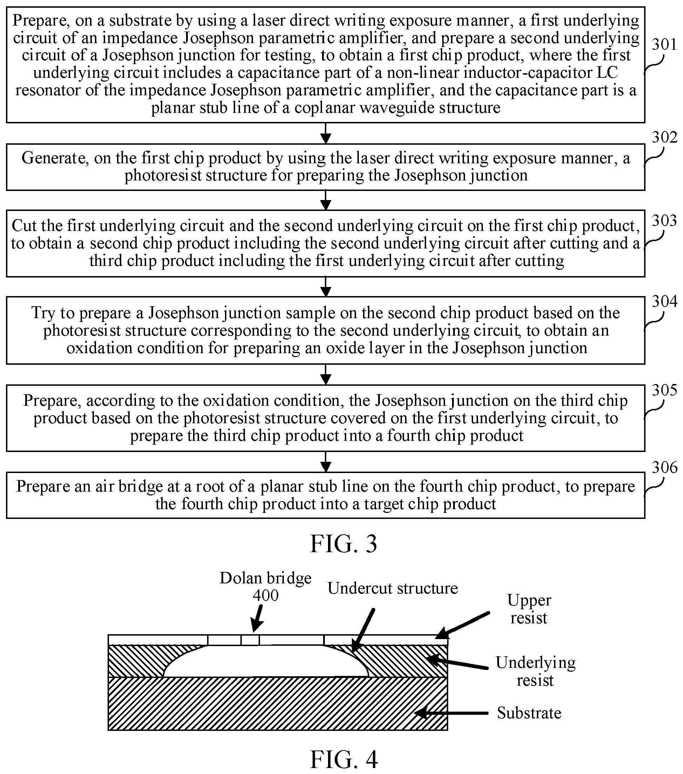

Based on the embodiment shown in FIG. 2, FIG. 3 is a method flowchart of a chip preparation method according to an exemplary embodiment of this application. As shown in FIG. 3, the chip preparation method may include the following steps.

Step 301: Prepare, on a substrate by using a laser direct writing exposure manner, a first underlying circuit of an impedance Josephson parametric amplifier, and prepare, on the substrate, a second underlying circuit of a Josephson junction for testing, to obtain a first chip product, where the first underlying circuit includes a capacitance part of a non-linear inductor-capacitor LC resonator of the impedance Josephson parametric amplifier, and the capacitance part is a planar stub line of a coplanar waveguide structure.

In some embodiments, the first underlying circuit and the second underlying circuit do not include a Josephson junction.

In the solution shown in this embodiment of this application, the planar stub line of the coplanar waveguide structure is used as the capacitance part of the non-linear inductor-capacitor LC resonator. This omits a process step of medium layer preparation, reduces an insertion loss, and simplifies process complexity and preparation difficulty.

A central conductor band is manufactured on one surface of a dielectric substrate, and conductor planes are manufactured on both sides adjacent to the central conductor band. This forms a coplanar waveguide, which is also referred to as a coplanar microband transmission line. A central conductor and a conductor plate are located in a same plane. Therefore, it is convenient to install components in parallel on the coplanar waveguide, and a monolithic microwave integrated circuit having a transmission line and components located on the same side may be manufactured.

In a possible implementation, the first underlying circuit further includes an impedance transformer of the impedance Josephson parametric amplifier.

A compensation bias exists between a line width of the impedance transformer in a layout and a designed line width of the impedance transformer, and the compensation bias is determined based on an etching bias obtained in a case that a third photoresist layer is etched. The third photoresist layer is a photoresist layer coated on an underlying circuit material after the underlying circuit material is deposited on the substrate.

For a problem that the impedance transformer has a strict line width requirement, in this embodiment of this application, in a case that the impedance transformer part of the impedance Josephson parametric amplifier is prepared by using the laser direct writing exposure manner, an "etching compensation" manner may be used, that is, an etching bias during actual processing is reserved in a layout, so that an actual processed line width is closer to a design requirement, and a success rate is higher.

For example, in this embodiment of this application, an actual bias may be reserved for the line width of the impedance transformer part during layout design. For example, a target value of an etching groove is 2 µm, and 1.7 µm is drawn during layout drawing (that is, an etching compensation is 0.3 µm). During actual etching, etching time is appropriately extended, to ensure that the etching groove is completely etched and the line width requirement is satisfied.

In a possible implementation, the process of preparing, on the substrate by using the laser direct writing exposure manner, the first underlying circuit of the impedance Josephson parametric amplifier and the second underlying circuit of the Josephson junction for testing, to obtain the first chip product may include the following steps:
S301a: Deposit an underlying circuit material on the substrate.
S301b: Coat a third photoresist layer on the underlying circuit material.
S301c: Expose and develop, in the third photoresist layer by using the laser direct writing exposure manner, etching areas corresponding to the first underlying circuit and the second underlying circuit.

In this embodiment of this application, the process of exposing and developing, in the third photoresist layer by using the laser direct writing exposure manner, the etching areas corresponding to the first underlying circuit and the second underlying circuit may include the following steps:
defining in the third photoresist layer by using a laser direct writing manner, circuit patterns of the first underlying circuit and the second underlying circuit; and
placing the substrate in a developer for development, to develop the etching areas corresponding to the first underlying circuit and the second underlying circuit.

The substrate and the material deposited on the substrate are placed in a developer for development, to obtain the etching areas corresponding to the first underlying circuit and the second underlying circuit.

S301d: Etch the third photoresist layer, to remove the underlying circuit material in the etching areas.

S301e: Clean off photoresist from the substrate, to obtain the first chip product.

In this embodiment of this application, through the foregoing process, an underlying metal layer, generally aluminum film, may be deposited on the substrate. Then, a coplanar waveguide structure of the impedance transformer and stub line capacitance, a pump driver structure, and a port circuit of a test junction array are prepared on the underlying metal layer through one exposure-development-etch process.

Step 302: Generate, on the first chip product by using the laser direct writing exposure manner, a photoresist structure for preparing the Josephson junction.

In a possible implementation, the photoresist structure for preparing the Josephson junction may be exposed through a bi-layer resist process.

In some embodiments, the photoresist structure may be a dolan bridge structure. For example, an underlying resist may select a photoresist of a lift off resist (LOR) series, and an upper resist may select S1813/S1805/SPR955 and other types of the photoresist. Junction area patterns of a Josephson junction sample array for testing and a formal Josephson junction are exposed by using a laser direct writing device. Then, the junction area pattern of the Josephson junction is developed and exposed. Because a dissolution rate of the underlying resist and a dissolution rate of a toplying photoresist are different in a developer, an undercut structure that is narrow at top and wide at bottom is formed after development. FIG. 4 is a schematic diagram of a photoresist structure involved in an embodiment of this application. As shown in FIG. 4, in a design structure of the Josephson junction, a suspended photoresist formed through communication between bottoms of two adjacent exposure areas is referred to as a dolan bridge 400.

Step 303: Cut the first underlying circuit and the second underlying circuit on the first chip product, to obtain a second chip product including the second underlying circuit and a third chip product including the first underlying circuit.

In some embodiments, with a goal of separating the first underlying circuit and the second underlying circuit, the first chip product is divided, to obtain the first underlying circuit and the second underlying circuit that are separated from each other after cutting. A chip part in which the second underlying circuit is located is used as the second chip product, and a chip part in which the first underlying circuit is located is used as the third chip product.

The first chip product is cut into the second chip product and the third chip product. The second chip product is a chip product obtained by cutting the second underlying circuit from the first chip product, and the third chip product is a chip product obtained by cutting the first underlying circuit from the first chip product.

Step 304: Trial produce a Josephson junction sample on the second chip product using the photoresist structure corresponding to the second underlying circuit, to obtain an oxidation condition for preparing an oxide layer in the Josephson junction.

In a possible implementation, the second underlying circuit includes a Josephson junction sample array. The Josephson junction sample array includes port circuits of at least two Josephson junction samples, and each port circuit corresponds to a group of photoresist structures.

The process of trial producing a Josephson junction sample on the second chip product using the photoresist structure corresponding to the second underlying circuit, to obtain an oxidation condition for preparing an oxide layer in the Josephson junction includes the following steps:
preparing, under a first oxidation condition using the photoresist structure a first port circuit, a Josephson junction sample corresponding to the first port circuit, where the first port circuit is a port circuit on which a Josephson junction sample has not been prepared in the port circuits of the at least two Josephson junction samples; and
determining, in a case that a first resistance value satisfies a design requirement, the first oxidation condition as the oxidation condition for preparing the oxide layer in the Josephson junction, where the first resistance value is obtained, based on the first port circuit, by measuring the Josephson junction sample corresponding to the first port circuit.

In some embodiments, in a case that the first resistance value does not satisfy the design requirement, the first oxidation condition and the first port circuit are updated to repeat the testing, until an oxidation condition that makes the first resistance value satisfy the design requirement is obtained.

In a possible implementation, the photoresist structure is a dolan bridge structure, and the process of preparing, under a first oxidation condition using the photoresist structure on a first port circuit, a Josephson junction sample corresponding to the first port circuit includes the following steps:
obliquely evaporating, using the photoresist structure on the first port circuit, a first superconducting layer of the Josephson junction sample corresponding to the first port circuit;
oxidizing the first superconducting layer under the first oxidation condition, to obtain an oxide insulation layer on a surface of the first superconducting layer; and
vertically evaporating, using the photoresist structure on the first port circuit, a second superconducting layer of the Josephson junction sample corresponding to the first port circuit, to obtain the Josephson junction sample corresponding to the first port circuit.

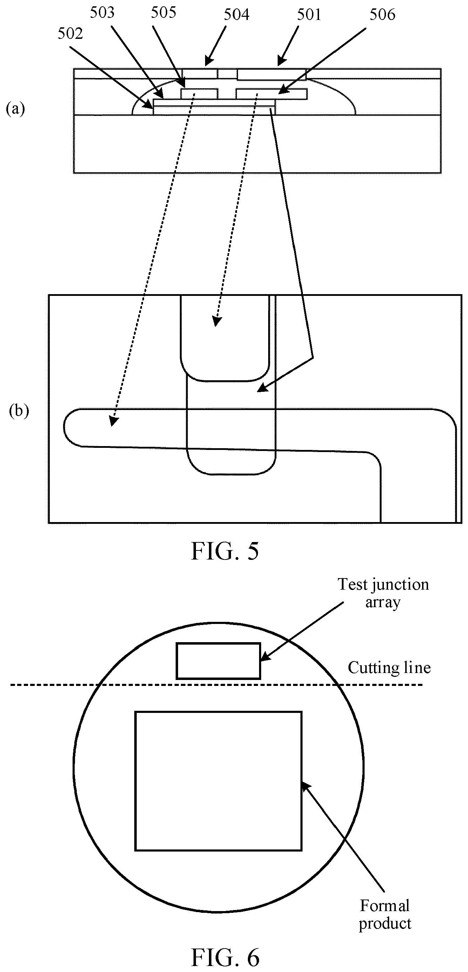

For example, FIG. 5 is a schematic diagram of preparing a Josephson junction prepared by using a dolan bridge according to an embodiment of this application. As shown in FIG. 5(a), based on a dolan bridge structure, first, a superconducting material is deposited on a substrate below the dolan bridge through a via 501 on the dolan bridge by using an oblique evaporation manner, to obtain a first superconducting layer 502 of the Josephson junction sample. Then, the first superconducting layer 502 is oxidized in an oxidation chamber, to obtain an oxide insulation layer 503 on a surface of the first superconducting layer 502. Then, the superconducting material is deposited on a substrate oxide insulation layer and the substrate below the dolan bridge through a via 504 on the dolan bridge by using a vertical evaporation manner, to obtain a second superconducting layer 505 of the Josephson junction sample. The first superconducting layer 502, the oxide insulation layer 503, and the second superconducting layer 505 form the Josephson junction/Josephson junction sample. In addition, due to existence of the via 501, during vertical evaporation, the superconducting material may also be deposited on the oxide insulation layer and the substrate through the via 501, to obtain a superconducting layer 506. For ease of description, in FIG. 5, the superconducting layer 506 is drawn as partially suspended. In an actual application, the suspended part of the superconducting layer 506 sinks to the substrate. The Josephson junction/Josephson junction sample prepared by the foregoing solution may be shown in FIG. 5(b).

In a possible implementation, the first oxidation condition includes at least one piece of the following information:
an air flow rate, pressure, and oxidation time of oxygen.
In the solution shown in the foregoing embodiment of this application, an oxidation condition that satisfies a requirement can be tested by using a manner of trial producing a Josephson junction sample on the second chip product in which the second underlying circuit is located by using various different oxidation conditions and measuring a resistance value of the Josephson junction sample. The oxidation condition includes conditions such as the air flow rate, the pressure, and the oxidation time of the oxygen. In some embodiments, other oxidation conditions, such as an air flow angle, and an oxidation temperature, may be further included. The oxidation condition is not limited in the embodiments of this application.

In some embodiments, in addition to the oxidation condition, when the Josephson junction sample is tried to be prepared by using the photoresist structure corresponding to the second underlying circuit, other conditions for preparing the Josephson junction sample may also be obtained, for example, evaporation time of the superconducting material of the Josephson junction, and an evaporation flow rate, an evaporation angle, a temperature, pressure, and the like of the superconducting material.

Step 305: Prepare, according to the oxidation condition, the Josephson junction on the third chip product using the photoresist structure on the first underlying circuit; to obtain a fourth chip product.

In this embodiment of this application, when the photoresist structure is the dolan bridge structure, the Josephson junction/Josephson junction sample may be prepared by dual-tilt electron beam evaporation.

For example, first, a first layer of superconducting aluminum film of the Josephson junction/Josephson junction sample is evaporated at a large tilt angle, where the tilt angle is related to a resist thickness to ensure that the first layer of aluminum film can pass through the dolan bridge. A specific flow of oxygen is introduced in a high vacuum environment to oxidize an upper surface of the first layer of aluminum film, to form an insulation layer of the Josephson junction/Josephson junction sample. Then, a second layer of aluminum film of the Josephson junction/Josephson junction sample is evaporated from the front at a vertical angle. After the evaporation is completed, the sample is placed in a resist remover to remove the photoresist lift off excess metal, to obtain a complete Josephson junction/Josephson junction sample.

In the solution shown in this embodiment of this application, the Josephson junction is exposed by using the laser direct writing manner. Compared with a conventional electron beam exposure manner, preparation of an overlay mark is omitted. Besides, a Josephson junction prepared by using the laser direct writing manner has a large size and has an advantage of being less prone to breakdown when used in a superconducting parametric amplifier component, and therefore has more stable performance. In addition, because of sensitivity the Josephson junction to a junction resistance parameter, a test junction array design is further added to a layout in this embodiment of this application. A test junction and a formal sample are exposed and developed at the same time to prepare junctions respectively, thereby ensuring that the junction resistance of a formal Josephson junction satisfies a designed value.

Step 306: Prepare an air bridge at a root of a planar stub line on the fourth chip product, to obtain a target chip product.

In a possible implementation, the process of preparing an air bridge at a root of a planar stub line on the fourth chip product, to obtain a target chip product includes the following steps:
coating a first photoresist layer on the fourth chip product;
exposing and developing a bridge pier area of the air bridge at a position of the first photoresist layer corresponding to the root of the planar stub line;
reflowing the first photoresist layer, to make the remaining photoresist in the first photoresist layer arched;
depositing a bridge material of the air bridge on the first photoresist layer;
coating a second photoresist layer on the bridge material;
exposing and developing an area outside a bridge of the air bridge in the second photoresist layer;
removing the bridge material outside the bridge of the air bridge by using an etching manner; and
cleaning a photoresist on the fourth chip product, to obtain the target chip product.

In a possible implementation, under the oxidation condition, a resistance value of the Josephson junction sample is less than a designed resistance value of the Josephson junction sample, and a resistance value difference between the resistance value of the Josephson junction sample and the designed resistance value of the Josephson junction sample matches a resistance value increment of the air bridge to the Josephson junction.

In the solution shown in this embodiment of this application, to reduce a parasitic mode brought by a capacitive structure of the planar stub line, an air bridge may be added at a root of the stub line. In addition, when the oxidation condition is selected, a magnitude relationship and a difference between the resistance value of the Josephson junction sample and the designed resistance value of the Josephson junction sample are referred, so that a problem of fluctuated resistance of the Josephson junction caused by an air bridge process is solved.

In this embodiment of this application, the air bridge may be prepared by a thick resist. For example, first, a photoresist SPR is evenly coated on the underlying aluminum film, to expose and develop a pattern of a bridge pier of the air bridge. The developer may use a developer that does not corrode the aluminum film, such as an AZdeveloper. Second, the sample is placed on a baking table and heated for reflow processing, to enable the photoresist to be arched and form a bridge shape. Third, a layer of aluminum film at a hundred nanometer level is evaporated on the photoresist as the bridge. The photoresist SPR is evenly coated on the aluminum film again, and the pattern of the bridge pier of the air bridge is exposed and developed. Fourth, the bridge structure is etched by using an acidic etching solution. Last, the sample is placed in a resist remover to remove the photoresist and lift off excess metal.

In the solution shown in this embodiment of this application, a method for preparing an impedance transformation Josephson parametric amplifier is provided. This design is sensitive to a parameter and has specific requirements on chip processing. The method has the following characteristics:
(1) Because the method is sensitive to a resistance value, it is required that an etching groove line width of a waveguide is accurate. In the solution shown in this embodiment of this application, an "etching compensation" manner is provided, that is, an etching bias during actual processing is reserved during layout drawing, and appropriate over-etching is performed, to ensure that the etching is complete and satisfies a line width requirement.
(2) In this embodiment of this application, a Josephson junction is exposed by using a laser direct writing manner. A basic idea is to use the laser direct writing exposure manner to form a specific pattern layer through a difference in solubility of an upper photoresist and a lower photoresist to a developer in a bi-layer resist process. Then, a coating machine is used to deposit a metal layer using the pattern layer as a mask, and after the metal layer is lifted off, a Josephson junction structure is obtained.
   In addition, because of the sensitivity of the Josephson junction to a junction resistance parameter, in this embodiment of this application, a test junction array design is added to a layout. An oxidation parameter is explored through a test junction, and after ideal junction resistance is obtained, junction preparation is performed on a formal sample.
(3) To suppress a parasitic mode brought by capacitance, an air bridge structure is introduced. The air bridge process may cause fluctuation to a junction resistance value of a prepared Josephson junction. In the solution shown in this embodiment of this application, target junction resistance may be obtained by selecting an oxidation condition.

In conclusion, according to the solution shown in this embodiment of this application, in a process of preparing the impedance Josephson parametric amplifier, the Josephson junction and other underlying circuits are prepared by using a laser direct writing manner. In addition, to ensure the preparation accuracy of the Josephson junction, a trial preparation process of the Josephson junction sample is introduced, to obtain the oxidation condition for formal preparation of the Josephson junction. This ensures preparation accuracy of the impedance Josephson parametric amplifier, reduces complexity of a preparation process of the impedance Josephson parametric amplifier, and increases preparation efficiency of the impedance Josephson parametric amplifier.

According to the method provided in this embodiment, the planar stub line of the coplanar waveguide structure is used as the capacitance part of the non-linear inductor-capacitor LC resonator. This omits a process step of medium layer preparation, reduces an insertion loss, and simplifies process complexity and preparation difficulty.

According to the method provided in this embodiment, to reduce a parasitic mode brought by a capacitive structure of the planar stub line, an air bridge may be added at a root of the stub line. In addition, when the oxidation condition is selected, a magnitude relationship and a difference between the resistance value of the Josephson junction sample and the designed resistance value of the Josephson junction sample are referred, so that a problem of fluctuated resistance of the Josephson junction caused by an air bridge process is solved.

A complete structure of the impedance transformation Josephson parametric amplifier involved in the foregoing embodiment of this application includes an input/output port, an impedance transformer, a non-linear LC resonator (including a planar capacitor and a non-linear inductor Josephson junction), a pump driver, a test junction array, and an air bridge structure. Patterns of the input/output port, the impedance transformer, the planar capacitor of the non-linear LC resonator, the pump driver, and a port of the test junction array may be prepared by once exposure and once etching by using a laser direct writing photo engraving process. A superconducting Josephson junction of the non-linear LC resonator is exposed by using a laser direct writing bi-layer resist process and prepared by using a double-tilt electron beam evaporation process. As the last step of the process, the air bridge structure is exposed by using twice laser direct writing and prepared by once evaporation coating.

Core processing indicators of an entire process include an accurate line width of the impedance transformer, and accurate junction resistance of the Josephson junction. To satisfy the indicator 1, in the solution shown in the foregoing embodiment of this application, a stable laboratory etching process is used to ensure that a deviation between an actual line width after each etching and a designed value is a stable value, and the deviation is compensated into a layout design. To satisfy the indicator 2, a test junction array is introduced, and the test junction array and a formal product are designed into a same substrate. FIG. 6 is a schematic diagram of a layout design involved in this application. As shown in FIG. 6, the test junction array and the formal product are exposed to the junction area at the same time. After the test junction array and the formal product are developed, the test junction array is separated. The oxidation condition of the Josephson junction evaporated and prepared by using a double-tilt electron beam is explored by using the test junction array, to obtain appropriate oxidation data. Then the formal sample is prepared by the Josephson junction. A junction resistance corresponding to an optimal oxidation condition should be slightly smaller than a resistance design value, because the last step of the air bridge process increases the junction resistance of the prepared Josephson junction. In a case that an experimental environment is stable, an increase value is generally stable.

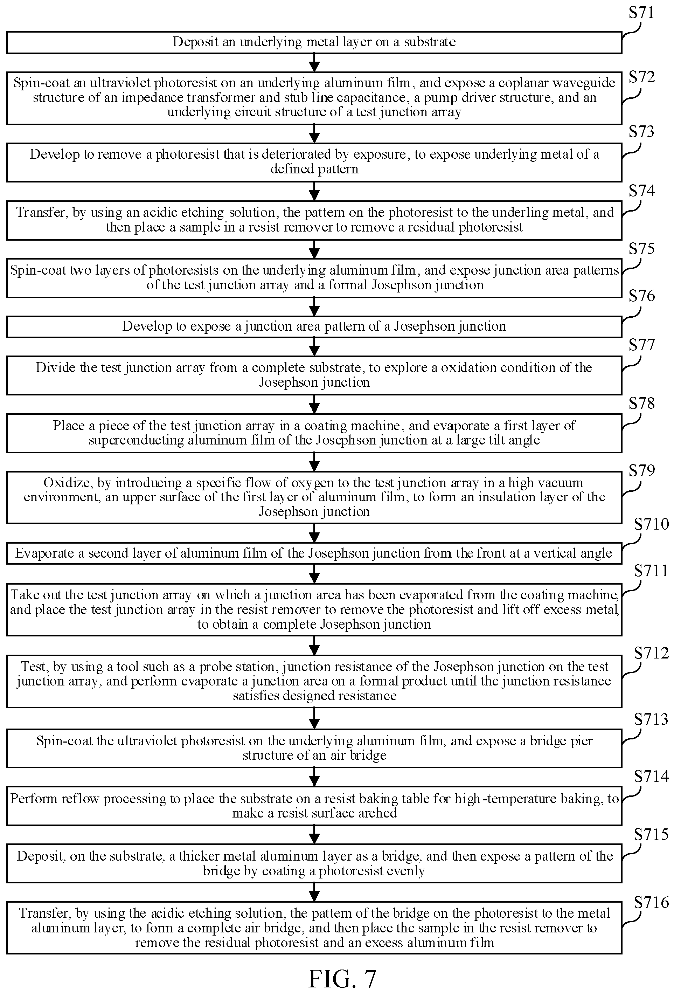

FIG. 7 is a schematic flowchart of preparing an impedance transformation Josephson parametric amplifier involved in this application. As shown in FIG. 7, the process may include the following steps.

S71: Deposit an underlying metal layer on a substrate.

Optionally, the metal layer is aluminum film. In some embodiments, the metal layer may further be other metal. Embodiments of this application does not limit this.

S72: Spin-coat an ultraviolet photoresist on an underlying aluminum film, and expose a coplanar waveguide structure of an impedance transformer and stub capacitance, a pump driver structure, and an underlying circuit structure of a test junction array.

Optionally, the ultraviolet photoresist is a S1805 photoresist.

S73: Develop to remove a photoresist that is deteriorated by exposure, to expose underlying metal of a defined pattern.

S74: Transfer, by using an acidic etching solution, the pattern on the photoresist to the underling metal, and then place a sample in a resist remover to remove a residual photoresist.

S75: Spin-coat two layers of photoresists on the underlying aluminum film, and expose junction area patterns of the test junction array and a formal Josephson junction.

An underlying resist is LOR series generally, and an upper resist is S1813/S1805/SPR955, or the like.

S76: Develop to expose a junction area pattern of a Josephson junction.

S77: Cut the test junction array from a complete substrate, to explore an oxidation condition of the Josephson junction.

S78: Place a piece of the test junction array in a coating machine, and evaporate a first layer of superconducting aluminum film of the Josephson junction at a large tilt angle,

that is, evaporate the Josephson junction.

S79: Oxidize, by introducing a specific flow of oxygen to the test junction array in a high vacuum environment for the test junction array, an upper surface of the first layer of aluminum film, to form an insulation layer of the Josephson junction.

S710: Evaporate a second layer of aluminum film of the Josephson junction from the front at a vertical angle.

S711: Take out the test junction array on which a junction area has been evaporated from the coating machine, and place the test junction array in the resist remover to remove the photoresist, and lift off excess metal, to obtain a complete Josephson junction.

S712: Test, by using a tool such as a probestation, the junction resistance of the Josephson junction on the test junction array, and perform evaporate a junction area on a formal product until the junction resistance satisfies design resistance.

Optionally, in a case that the junction resistance of the Josephson junction on the test junction array is tested, fluctuated junction resistance of the Josephson junction caused by a subsequent air bridge process needs to be considered. In a case that an experimental environment is stable, a change rate of the junction resistance caused by the air bridge process is also stable. In a case that the junction resistance of the test junction array satisfies a design value after removing an influence of the air bridge, a next air bridge preparation process is performed. In a case that the junction resistance does not satisfy the design value influenced by the air bridge, a next piece of the test junction array is selected to re-perform step S78 to step S712. After the junction resistance satisfies the design resistance, evaporation from step S78 to step S712 is performed on the formal product in the junction area.

S713: Spin-coat the ultraviolet photoresist SPR on the underlying aluminum film, and expose a pier structure of an air bridge.

S714: Perform reflow processing to place the substrate on a resist baking table for high-temperature baking, to make a resist surface arched.

S715: Deposit, on the substrate, a thicker metal aluminum layer as a bridge, and then expose a pattern of the bridge by coating a photoresist evenly.

S716: Transfer, by using the acidic etching solution, the pattern of the bridge on the photoresist to the metal aluminum layer, to form a complete air bridge, and then place the sample in the resist remover to remove the residual photoresist and an excess aluminum film.

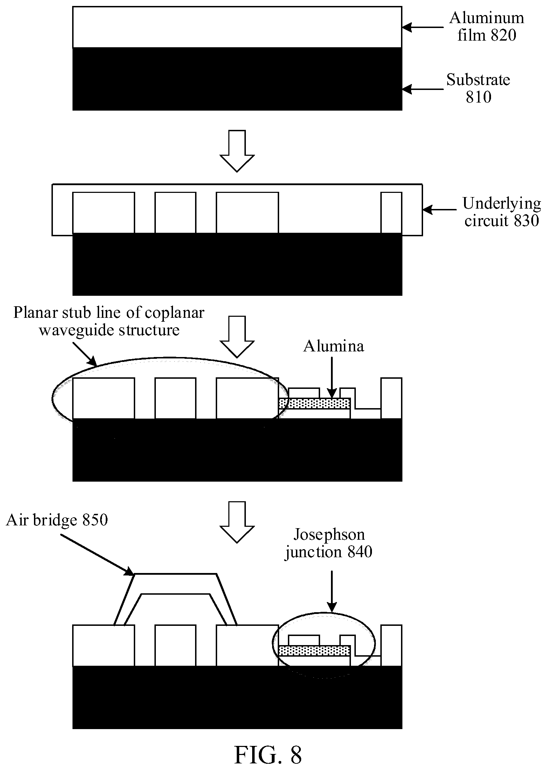

FIG. 8 is a schematic diagram of a product form change in a process of preparing an impedance transformation Josephson parametric amplifier involved in an embodiment of this application. As shown in FIG. 8, first, an underlying metal layer is deposited on a substrate 810, that is metal aluminum film 820. An ultraviolet photoresist is spin-coated on underlying aluminum film 820. A coplanar waveguide structure of an impedance transformer and stub capacitance, a pump driver structure, and an underlying circuit structure 830 of a test junction array are exposed. A pattern on a photoresist is transferred to an underling metal by using an acidic etching solution, and then a sample is placed in a resist remover to remove a residual photoresist. Two layers of photoresists are spin-coated on the underlying aluminum film, and junction area patterns of the test junction array and a formal Josephson junction are exposed. A junction area pattern of a Josephson junction is developed to evaporate a Josephson junction 840, and an air bridge 850 is obtained through preparation.

In embodiments of this application, an impedance transformation Josephson parametric amplifier preparation method is provided. A problem caused in a case that a parametric amplifier has a strict line width requirement and junction resistance of an impedance transformer is solved through "etching compensation" and by using a method that a test junction array explores an oxidation condition. This improves component performance. Compared with a conventional electron beam exposure manner, preparation of an overlay mark is omitted by using a laser direct writing manner, and is easy to be lifted off. A Josephson junction prepared has a large size and has an advantage of being less prone to breakdown when used in a superconducting parametric amplifier component, and therefore has more stable performance.

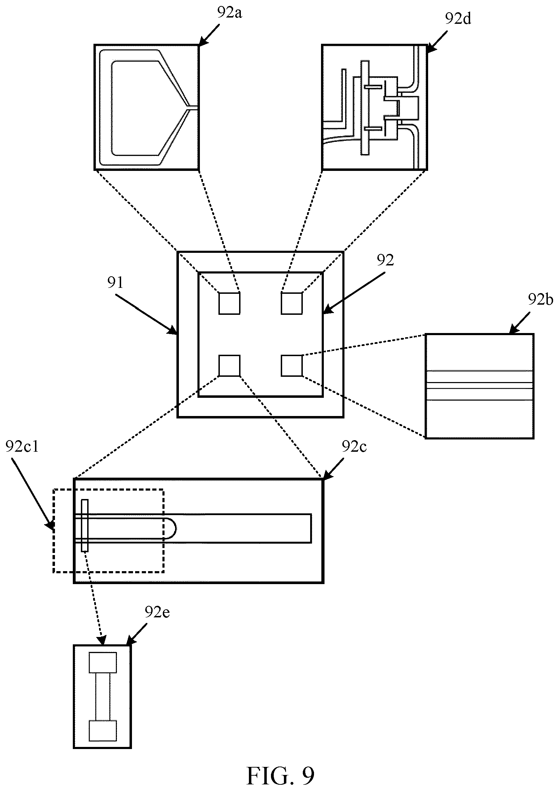

FIG. 9 is a schematic diagram of a structural of a chip provided according to an exemplary embodiment of this application. As shown in FIG. 9, the chip includes
a substrate 91, and an impedance Josephson parametric amplifier 92 on the substrate. The impedance Josephson parametric amplifier 92 includes a signal input and output port 92a, an impedance transformer 92b, a non-linear inductor-capacitor LC resonator 92c, a Josephson junction and a pumping structure 92d. A Capacitance part 92c1 of the non-linear LC resonator 92c is planar stub line of a coplanar waveguide structure.

In a possible implementation, as shown in FIG. 9, a root of the planar stub line includes an air bridge 92e.

The chip is a chip product prepared based on the method shown in FIG. 2, FIG. 3, or FIG. 6.

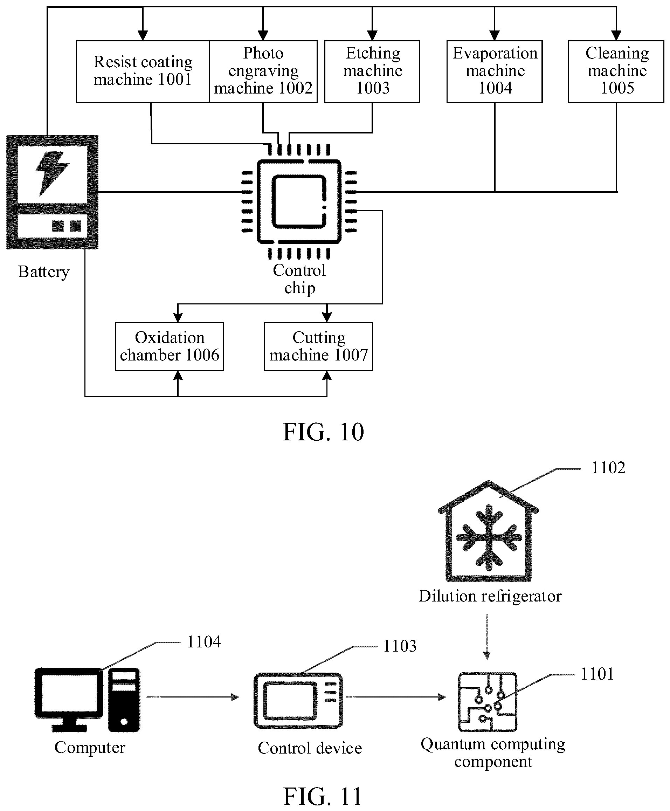

FIG. 10 is a schematic diagram of a chip preparation system according to an exemplary embodiment of this application. The chip preparation system may be implemented as a production line device. As shown in FIG. 8, the chip preparation system includes a resist coating machine 1001, a photo engraving machine 1002, an etching machine 1003, an evaporation machine 1004, a cleaning machine 1005, an oxidation chamber 1006, and a cutting machine 1007.

The resist coating machine 1001, the photo engraving machine 1002, the evaporation machine 1004, the etching machine 1003, and the cleaning machine 1005 are configured to prepare, by using a laser direct writing exposure manner, a first underlying circuit of an impedance Josephson parametric amplifier on a substrate and a second underlying circuit of a Josephson junction for testing, to obtain a first chip product.

The resist coating machine 1001 and the photo engraving machine 1002 is configured to generate, on the first chip product by using a laser direct writing exposure manner, a photoresist structure for preparing the Josephson junction.

The cutting machine 1007 is configured to cut the first underlying circuit and the second underlying circuit on the first chip product, to obtain a second chip product including the second underlying circuit and a third chip product including the first underlying circuit.

The evaporation machine 1004 and the oxidation chamber 1006 are configured to trial produce, on the second chip product using the photoresist structure on the second underlying circuit, a Josephson junction sample, to obtain an oxidation condition for preparing an oxide layer in the Josephson junction.

The evaporation machine 1004 and the oxidation chamber 1006 are further configured to: prepare, according to the oxidation condition, the Josephson junction on the third chip product using the photoresist structure on the first underlying circuit, to obtain a fourth chip product.

The resist coating machine 1001, the photolithography machine 1002, the evaporation machine 1004, the etching machine 1003, and the cleaning machine 1005 are further configured to: obtain, based on the fourth chip product, a target chip product including the impedance Josephson parametric amplifier.

In a possible implementation, the first underlying circuit includes a capacitance part of a non-linear inductor-capacitor LC resonator of the impedance Josephson parametric amplifier, and
the capacitance part is a planar stub line of a coplanar waveguide structure.

In a possible implementation, the resist coating machine 1001, the photolithography machine 1002, the evaporation machine 1004, the etching machine 1003, and the cleaning machine 1005 are configured to: prepare an air bridge at a root of the planar stub line on the fourth chip product; and prepare the fourth chip product to a target chip product.

In a possible implementation, the process of preparing the air bridge at the root of the planar stub line on the fourth chip product, to obtain the target chip product includes the following steps:

The resist coating machine 1001 is configured to coat a first photoresist layer on the fourth chip product.

The photolithography machine 1002 is configured to: expose and develop a bridge pier area of the air bridge at a position of the first photoresist layer corresponding to the root of the planar stub line; and
reflow the first photoresist layer, to make the remaining photoresist in the first photoresist layer arched.

The evaporation machine 1004 is configured to deposit a bridge material of the air bridge on the arched first photoresist layer.

The resist coating machine 1001 is configured to coat a second photoresist layer on the bridge material.

The photolithography machine 1002 is configured to expose and develop an area outside a bridge of the air bridge in the second photoresist layer.

The etching machine 1003 is configured to remove the bridge material outside the bridge of the air bridge by using an etching method.

The cleaning machine 1005 is configured to clean a photoresist on the fourth chip product, to obtain the target chip product.

In a possible implementation, under the oxidation condition, a resistance value of the Josephson junction sample is less than a designed resistance value of the Josephson junction sample, and the resistance value difference between the resistance value of the Josephson junction sample and the designed resistance value of the Josephson junction sample matches a resistance value increment of the air bridge to the Josephson junction.

In a possible implementation, the evaporation machine 1004 is configured to deposit an underlying circuit material on the substrate.

The resist coating machine 1001 is configured to coat a third photoresist layer on the underlying circuit material.

The photolithography machine 1002 is configured to expose and develop, in the third photoresist layer by using the laser direct writing exposure manner, etching areas corresponding to the first underlying circuit and the second underlying circuit.

The etching machine 1003 is configured to etch the third photoresist layer, to remove the underlying circuit material in the etching areas.

The cleaning machine 1005 is configured to clean off photoresist from the substrate, to obtain the first chip product.

In a possible implementation, the photolithography machine 1002 is configured to: define, in the third photoresist layer by using a laser direct writing manner, circuit patterns of the first underlying circuit and the second underlying circuit; place the substrate in a developer for development, to develop the etching areas corresponding to the first underlying circuit and the second underlying circuit.

In a possible implementation, the first underlying circuit includes an impedance transformer of the impedance Josephson parametric amplifier.

A compensation bias exists between a line width of the impedance transformer in a layout and a designed line width of the impedance transformer, and the compensation bias is determined based on an etching bias of an etching processing on the third photoresist layer.

In a possible implementation, the second underlying circuit includes a Josephson junction sample array. The Josephson junction sample array includes port circuits of at least two Josephson junction samples, and each port circuit corresponds to a group of photoresist structures.

The evaporation machine 1004 and the oxidation chamber 1006 are configured to: prepare, under a first oxidation condition using the photoresist structure on a first port circuit, the Josephson junction sample corresponding to the first port circuit, where the first port circuit is a port circuit on which a Josephson junction sample has not been prepared in the port circuits of the at least two Josephson junction samples.

In a case that a first resistance value satisfies a design requirement, the first oxidation condition is determined as the oxidation condition for preparing the oxide layer in the Josephson junction, where the first resistance value is obtained, based on the first port circuit, by measuring the Josephson junction sample corresponding to the first port circuit.

In a possible implementation, the oxidation chamber 1006 is further configured to:
update the first oxidation condition and test the first port circuit in a case that the first resistance value does not satisfy the design requirement.

In a possible implementation, the photoresist structure is a dolan bridge structure.

The evaporation machine 1004 is configured to obliquely evaporate, using the photoresist structure on the first port circuit, a first superconducting layer of the Josephson junction sample corresponding to the first port circuit.

The oxidation chamber 1006 is configured to oxidize the first superconducting layer under the first oxidation condition, to obtain an oxide insulation layer on a surface of the first superconducting layer.

The evaporation machine 1004 is configured to: vertically evaporate, using the photoresist structure on the first port circuit, a second superconducting layer of the Josephson junction sample that corresponds to the first port circuit, to obtain the Josephson junction sample corresponding to the first port circuit.

In a possible implementation, the first oxidation condition includes at least one piece of the following information:
an air flow rate, pressure, and oxidation time of oxygen.

FIG. 11 is a schematic diagram of a solution application scenario according to an embodiment of this application. As shown in FIG. 11, the application scenario may be a superconducting quantum computing platform, and the application scenario includes a quantum computing component 1101, a dilution refrigerator 1102, a control device 1103 and a computer 1104.

The quantum computing component 1101 is a circuit that acts on physical qubits. The quantum computing component 1101 may be realized as a quantum chip, such as a superconducting quantum chip near absolute zero. The quantum chip may be obtained through preparation of the scheme shown in the foregoing embodiments of this application. The dilution refrigerator 1102 is configured to provide an absolute zero environment for a superconducting quantum chip.

The control device 1103 is configured to control the quantum computing component 1101, and the computer 1104 is configured to control the control device 1103. For example, a written quantum program is compiled, by using software in the computer 1104, into instructions, and the instructions are sent to the control device 1103 (such as an electronic/microwave control system). The control device 1103 transfers the instructions into an electronic/microwave control signal, inputs the electronic/microwave control signal to the dilution refrigerator 1102, and controls the superconducting qubits at temperature less than 10mK. A reading process is on the contrary. Waveform is read and sent to the quantum computing component 1101.

## Claims

1. A chip preparation method, the method comprising:
preparing (201), on a substrate by using a laser direct writing exposure manner, a first underlying circuit of an impedance matching Josephson parametric amplifier, and preparing, on the substrate, a second underlying circuit of a Josephson junction for testing, to obtain a first chip product;
generating (202), on the first chip product by using the laser direct writing exposure manner, a photoresist structure for preparing the Josephson junction;
cutting (203) the first underlying circuit and the second underlying circuit on the first chip product, to obtain a second chip product comprising the second underlying circuit and a third chip product comprising the first underlying circuit;
trial producing (204) a Josephson junction sample on the second chip product using the photoresist structure on the second underlying circuit, to determine an oxidation condition for preparing an oxide layer in the Josephson junction;
preparing (205), according to the oxidation condition, a Josephson junction on the third chip product using the photoresist structure on the first underlying circuit, to obtain a fourth chip product; and
obtaining (206), based on the fourth chip product, a target chip product comprising the impedance matching Josephson parametric amplifier.

2. The method according to claim 1, wherein the first underlying circuit comprises a capacitance part of a non-linear inductor-capacitor LC resonator of the impedance matching Josephson parametric amplifier; and
the capacitance part is a planar stub line of a coplanar waveguide structure.

3. The method according to claim 2, wherein the obtaining, based on the fourth chip product, a target chip product comprising the impedance matching Josephson parametric amplifier comprises:
preparing an air bridge at a root of the planar stub line on the fourth chip product, to obtain the target chip product.

4. The method according to claim 3, wherein the preparing an air bridge at a root of the planar stub line on the fourth chip product; to obtain the target chip product comprises:
coating a first photoresist layer on the fourth chip product;
exposing and developing a bridge pier area of the air bridge at a position of the first photoresist layer corresponding to the root of the planar stub line;
reflowing the first photoresist layer, to obtain an arched first photoresist layer;
depositing a bridge material of the air bridge on the arched first photoresist layer;
coating a second photoresist layer on the bridge material;
exposing and developing an area outside a bridge of the air bridge in the second photoresist layer;
removing the bridge material outside the bridge of the air bridge by using an etching manner; and
cleaning a photoresist on the fourth chip product, to obtain the target chip product.

5. The method according to claim 3, wherein under the oxidation condition, a resistance value of the Josephson junction sample is less than a designed resistance value of the Josephson junction, and a resistance value difference between the resistance value of the Josephson junction sample and the designed resistance value of the Josephson junction matches a resistance value increment of the air bridge to the Josephson junction.

6. The method according to any one of claims 1 to 5, wherein the preparing, on a substrate by using a laser direct writing exposure manner, a first underlying circuit of an impedance matching Josephson parametric amplifier, and preparing, on the substrate, a second underlying circuit of a Josephson junction for testing, to obtain a first chip product comprises:
depositing an underlying circuit material on the substrate;
coating a third photoresist layer on the underlying circuit material;
exposing and developing, in the third photoresist layer by using the laser direct writing exposure manner, etching areas corresponding to the first underlying circuit and the second underlying circuit;
etching the third photoresist layer, to remove the underlying circuit material in the etching areas; and
cleaning off a photoresist from the substrate, to obtain the first chip product.

7. The method according to claim 6, wherein the exposing and developing, in the third photoresist layer by using the laser direct writing exposure manner, etching areas corresponding to the first underlying circuit and the second underlying circuit comprises:
defining, in the third photoresist layer by using a laser direct writing manner, circuit patterns of the first underlying circuit and the second underlying circuit; and
placing the substrate in a developer for development, to develop the etching areas corresponding to the first underlying circuit and the second underlying circuit.

8. The method according to claim 7, wherein the first underlying circuit comprises an impedance transformer of the impedance matching Josephson parametric amplifier; and
a compensation bias exists between a line width of the impedance transformer in a layout and a designed line width of the impedance transformer, and the compensation bias is determined based on an etching bias of an etching processing on the third photoresist layer.

9. The method according to any one of claims 1 to 8, wherein the second underlying circuit comprises a Josephson junction sample array, the Josephson junction sample array comprises port circuits of at least two Josephson junction samples, and each of the port circuits corresponds to a group of photoresist structures; and
the trial producing a Josephson junction sample on the second chip product using the photoresist structure on the second underlying circuit, to determine an oxidation condition for preparing an oxide layer in the Josephson junction comprises:
preparing, under a first oxidation condition using the photoresist structure on a first port circuit, a Josephson junction sample corresponding to the first port circuit, wherein the first port circuit is a port circuit on which a Josephson junction sample has not been prepared in the port circuits of the at least two Josephson junction samples; and
determining, in a case that a first resistance value satisfies a design requirement, the first oxidation condition as the oxidation condition for preparing the oxide layer in the Josephson junction, wherein the first resistance value is obtained, based on the first port circuit, by measuring the Josephson junction sample corresponding to the first port circuit.

10. The method according to claim 9, wherein the method further comprises:
updating the first oxidation condition and the first port circuit to perform the test, in a case that the first resistance value does not satisfy the design requirement.

11. The method according to claim 9, wherein the photoresist structure is a dolan bridge structure, and the preparing, under a first oxidation condition using the photoresist structure on a first port circuit, a Josephson junction sample corresponding to the first port circuit comprises:
obliquely evaporating, using the photoresist structure on the first port circuit, a first superconducting layer of the Josephson junction sample corresponding to the first port circuit;
oxidizing the first superconducting layer under the first oxidation condition, to obtain an oxide insulation layer on a surface of the first superconducting layer; and
vertically evaporating, using the photoresist structure on the first port circuit, a second superconducting layer of the Josephson junction sample corresponding to the first port circuit, to obtain the Josephson junction sample corresponding to the first port circuit.

12. The method according to claim 11, wherein the first oxidation condition comprises at least one of:
an air flow rate of an oxygen gas,
a pressure of the oxygen gas, and
an oxidation time period.

13. A chip preparation system, the system comprising: a resist coating machine (1001), a photo engraving machine (1002), an evaporation machine (1004), an etching machine (1003), an oxidation chamber (1006), a cleaning machine (1005), and a cutting machine (1007);
the resist coating machine, the photo engraving machine, the evaporation machine, the etching machine, and the cleaning machine being configured to: prepare (201), by using a laser direct writing exposure manner, a first underlying circuit of an impedance matching Josephson parametric amplifier on a substrate, and prepare a second underlying circuit of a Josephson junction for testing on the substrate, to obtain a first chip product;
the resist coating machine and the photo engraving machine being configured to: generate (202), on the first chip product by using the laser direct writing exposure manner, a photoresist structure for preparing the Josephson junction;
the cutting machine being configured to cut (203) the first underlying circuit and the second underlying circuit on the first chip product, to obtain a second chip product comprising the second underlying circuit and a third chip product comprising the first underlying circuit;
the evaporation machine and the oxidation chamber being configured to trial produce (204) a Josephson junction sample on the second chip product using the photoresist structure on the second underlying circuit, to determine an oxidation condition for preparing an oxide layer in the Josephson junction;
the evaporation machine and the oxidation chamber being further configured to: prepare (205), according to the oxidation condition, a Josephson junction on the third chip product using the photoresist structure on the first underlying circuit, to obtain a fourth chip product; and
the resist coating machine, the photo engraving machine, the evaporation machine, the etching machine, and the cleaning machine being further configured to: obtain (206), based on the fourth chip product, a target chip product comprising the impedance matching Josephson parametric amplifier.

## Patentansprüche

1. Chipherstellungsverfahren, wobei das Verfahren umfasst:
das Herstellen (201), auf einem Substrat unter Verwendung einer direkt schreibenden Laserbelichtungsart, einer ersten Grundschaltung eines impedanzangepassten Josephson-Parameterverstärkers und das Herstellen, auf dem Substrat, einer zweiten Grundschaltung einer Josephson-Kontaktstelle zum Testen, um ein erstes Chipprodukt zu erhalten;
das Erzeugen (202), auf dem ersten Chipprodukt unter Verwendung der direkt schreibenden Laserbelichtungsart, einer Fotolackstruktur zur Herstellung der Josephson-Kontaktstelle;
das Schneiden (203) der ersten Grundschaltung und der zweiten Grundschaltung auf dem ersten Chipprodukt, um ein zweites Chipprodukt, das die zweite Grundschaltung umfasst, und ein drittes Chipprodukt, das die erste Grundschaltung umfasst, zu erhalten;
das Probeherstellen (204) einer Josephson-Kontaktstellen-Probe auf dem zweiten Chipprodukt unter Verwendung der Fotolackstruktur auf der zweiten Grundschaltung, um eine Oxidationsbedingung zur Herstellung einer Oxidschicht in der Josephson-Kontaktstelle zu bestimmen;
das Herstellen (205), gemäß der Oxidationsbedingung, der Josephson-Kontaktstelle auf dem dritten Chipprodukt unter Verwendung der Fotolackstruktur auf der ersten Grundschaltung, um ein viertes Chipprodukt zu erhalten; und
das Erhalten (206), auf Basis des vierten Chipprodukts, eines Ziel-Chipprodukts, das den impedanzangepassten Josephson-Parameterverstärker umfasst.

2. Verfahren nach Anspruch 1, wobei die erste Grundschaltung einen Kapazitätsteil eines nichtlinearen Induktivitäts-Kapazitäts-LC-Resonators des impedanzangepassten Josephson-Parameterverstärkers umfasst; und
der Kapazitätsteil eine planare Stub-Leitung einer koplanaren Wellenleiterstruktur ist.

3. Verfahren nach Anspruch 2, wobei das Erhalten, auf Basis des vierten Chipprodukts, eines Ziel-Chipprodukts, das den impedanzangepassten Josephson-Parameterverstärker umfasst, umfasst:
das Herstellen einer Luftbrücke an einer Wurzel der planaren Stub-Leitung auf dem vierten Chipprodukt, um das Ziel-Chipprodukt zu erhalten.

4. Verfahren nach Anspruch 3, wobei das Herstellen einer Luftbrücke an einer Wurzel der planaren Stub-Leitung auf dem vierten Chipprodukt; um das Ziel-Chipprodukt zu erhalten, umfasst:
das Aufbringen einer ersten Fotolackschicht auf dem vierten Chipprodukt;
das Belichten und Entwickeln eines Brückenpfeilerbereichs der Luftbrücke an einer Position der ersten Fotolackschicht, die der Wurzel der planaren Stub-Leitung entspricht;
das Aufschmelzen der ersten Fotolackschicht, um eine gewölbte erste Fotolackschicht zu erhalten;
das Abscheiden eines Brückenmaterials der Luftbrücke auf der gewölbten ersten Fotolackschicht;
das Aufbringen einer zweiten Fotolackschicht auf dem Brückenmaterial;
das Belichten und Entwickeln eines Bereichs außerhalb einer Brücke der Luftbrücke in der zweiten Fotolackschicht;
das Entfernen des Brückenmaterials außerhalb der Brücke der Luftbrücke mittels eines Ätzverfahrens; und
das Reinigen eines Fotolacks auf dem vierten Chipprodukt, um das Ziel-Chipprodukt zu erhalten.

5. Verfahren nach Anspruch 3, wobei unter der Oxidationsbedingung ein Widerstandswert der Josephson-Kontaktstellen-Probe kleiner als ein auslegungsbedingter Widerstandswert der Josephson-Kontaktstelle ist, und eine Widerstandswertdifferenz zwischen dem Widerstandswert der Josephson-Kontaktstellen-Probe und dem auslegungsbedingten Widerstandswert der Josephson-Kontaktstelle einem Widerstandswertinkrement der Luftbrücke gegenüber der Josephson-Kontaktstelle entspricht.

6. Verfahren nach einem der Ansprüche 1 bis 5, wobei das Herstellen, auf einem Substrat unter Verwendung einer direkt schreibenden Laserbelichtungsart, einer ersten Grundschaltung eines impedanzangepassten Josephson-Parameterverstärkers und das Herstellen, auf dem Substrat, einer zweiten Grundschaltung einer Josephson-Kontaktstelle zum Testen, um ein erstes Chipprodukt zu erhalten, umfasst:
das Abscheiden eines Grundschaltungsmaterials auf dem Substrat;
das Aufbringen einer dritten Fotolackschicht auf dem Grundschaltungsmaterial;
das Belichten und Entwickeln, in der dritten Fotolackschicht unter Verwendung der direkt schreibenden Laserbelichtungsart, von Ätzbereichen, die der ersten Grundschaltung und der zweiten Grundschaltung entsprechen;
das Ätzen der dritten Fotolackschicht, um das Grundschaltungsmaterial in den Ätzbereichen zu entfernen; und
das Entfernen eines Fotolacks vom Substrat, um das erste Chipprodukt zu erhalten.

7. Verfahren nach Anspruch 6, wobei das Belichten und Entwickeln, in der dritten Fotolackschicht unter Verwendung der direkt schreibenden Laserbelichtungsart, von Ätzbereichen, die der ersten Grundschaltung und der zweiten Grundschaltung entsprechen, umfasst:
das Definieren, in der dritten Fotolackschicht unter Verwendung einer direkt schreibenden Laserart, von Schaltungsmustern der ersten Grundschaltung und der zweiten Grundschaltung; und
das Einlegen des Substrats in ein Entwicklungsmittel zur Entwicklung, um die Ätzbereiche, die der ersten Grundschaltung und der zweiten Grundschaltung entsprechen, zu entwickeln.

8. Verfahren nach Anspruch 7, wobei die erste Grundschaltung einen Impedanztransformator des impedanzangepassten Josephson-Parameterverstärkers umfasst; und
eine Kompensationsabweichung zwischen einer Leitungsbreite des Impedanztransformators in einem Layout und einer auslegungsbedingten Leitungsbreite des Impedanztransformators besteht, und die Kompensationsabweichung auf Basis einer Ätzabweichung eines Ätzprozesses auf der dritten Fotolackschicht bestimmt wird.

9. Verfahren nach einem der Ansprüche 1 bis 8, wobei die zweite Grundschaltung ein Josephson-Kontaktstellen-Probenarray umfasst, das Josephson-Kontaktstellen-Probenarray Portschaltungen von mindestens zwei Josephson-Kontaktstellen-Proben umfasst, und jede der Portschaltungen einer Gruppe von Fotolackstrukturen entspricht; und
das Probeherstellen einer Josephson-Kontaktstellen-Probe auf dem zweiten Chipprodukt unter Verwendung der Fotolackstruktur auf der zweiten Grundschaltung, um eine Oxidationsbedingung zur Herstellung einer Oxidschicht in der Josephson-Kontaktstelle zu bestimmen, umfasst:
das Herstellen, in einer ersten Oxidationsbedingung unter Verwendung der Fotolackstruktur auf einer ersten Portschaltung, einer Josephson-Kontaktstellen-Probe, die der ersten Portschaltung entspricht, wobei die erste Portschaltung eine Portschaltung ist, auf der in den Portschaltungen der mindestens zwei Josephson-Kontaktstellen-Proben noch keine Josephson-Kontaktstellen-Probe hergestellt worden ist; und
das Bestimmen, in dem Fall, dass ein erster Widerstandswert eine Auslegungsanforderung erfüllt, der ersten Oxidationsbedingung als der Oxidationsbedingung zur Herstellung der Oxidschicht in der Josephson-Kontaktstelle, wobei der erste Widerstandswert auf Basis der ersten Portschaltung durch Messen der der ersten Portschaltung entsprechenden Josephson-Kontaktstellen-Probe erhalten wird.

10. Verfahren nach Anspruch 9, wobei das Verfahren ferner umfasst:
das Aktualisieren der ersten Oxidationsbedingung und der ersten Portschaltung zur Durchführung des Tests, in dem Fall, dass der erste Widerstandswert die Auslegungsanforderung nicht erfüllt.

11. Verfahren nach Anspruch 9, wobei die Fotolackstruktur eine Dolan-Brückenstruktur ist, und das Herstellen, in einer ersten Oxidationsbedingung unter Verwendung der Fotolackstruktur auf einer ersten Portschaltung, einer Josephson-Kontaktstellen-Probe, die der ersten Portschaltung entspricht, umfasst:
das Schrägbedampfen, unter Verwendung der Fotolackstruktur auf der ersten Portschaltung, einer ersten supraleitenden Schicht der der ersten Portschaltung entsprechenden Josephson-Kontaktstellen-Probe;
das Oxidieren der ersten supraleitenden Schicht unter der ersten Oxidationsbedingung, um eine Oxidisolierschicht auf einer Oberfläche der ersten supraleitenden Schicht zu erhalten; und
das senkrechte Bedampfen, unter Verwendung der Fotolackstruktur auf der ersten Portschaltung, einer zweiten supraleitenden Schicht der der ersten Portschaltung entsprechenden Josephson-Kontaktstellen-Probe, um die der ersten Portschaltung entsprechende Josephson-Kontaktstellen-Probe zu erhalten.

12. Verfahren nach Anspruch 11, wobei die erste Oxidationsbedingung mindestens eines der folgenden umfasst:
eine Luftdurchflussrate eines Sauerstoffgases,
einen Druck des Sauerstoffgases, und
eine Oxidationszeitdauer.

13. Chipherstellungssystem, wobei das System umfasst: eine Lackbeschichtungsmaschine (1001), eine Fotograviermaschine (1002), eine Bedampfungsmaschine (1004), eine Ätzmaschine (1003), eine Oxidationskammer (1006), eine Reinigungsmaschine (1005) und eine Schneidemaschine (1007); wobei die Lackbeschichtungsmaschine, die Fotograviermaschine, die Bedampfungsmaschine, die Ätzmaschine und die Reinigungsmaschine konfiguriert sind zum: Herstellen (201), unter Verwendung einer direkt schreibenden Laserbelichtungsart, einer ersten Grundschaltung eines impedanzangepassten Josephson-Parameterverstärkers auf einem Substrat, und Herstellen einer zweiten Grundschaltung einer Josephson-Kontaktstelle zum Testen auf dem Substrat, um ein erstes Chipprodukt zu erhalten;
wobei die Lackbeschichtungsmaschine und die Fotograviermaschine konfiguriert sind zum: Erzeugen (202), auf dem ersten Chipprodukt unter Verwendung der direkt schreibenden Laserbelichtungsart, einer Fotolackstruktur zur Herstellung der Josephson-Kontaktstelle;
wobei die Schneidemaschine konfiguriert ist zum Schneiden (203) der ersten Grundschaltung und der zweiten Grundschaltung auf dem ersten Chipprodukt, um ein zweites Chipprodukt, das die zweite Grundschaltung umfasst, und ein drittes Chipprodukt, das die erste Grundschaltung umfasst, zu erhalten;
wobei die Bedampfungsmaschine und die Oxidationskammer konfiguriert sind zum Probeherstellen (204) einer Josephson-Kontaktstellen-Probe auf dem zweiten Chipprodukt unter Verwendung der Fotolackstruktur auf der zweiten Grundschaltung, um eine Oxidationsbedingung zur Herstellung einer Oxidschicht in der Josephson-Kontaktstelle zu bestimmen;
wobei die Bedampfungsmaschine und die Oxidationskammer ferner konfiguriert sind zum: Herstellen (205), gemäß der Oxidationsbedingung, der Josephson-Kontaktstelle auf dem dritten Chipprodukt unter Verwendung der Fotolackstruktur auf der ersten Grundschaltung, um ein viertes Chipprodukt zu erhalten; und
wobei die Lackbeschichtungsmaschine, die Fotograviermaschine, die Bedampfungsmaschine, die Ätzmaschine und die Reinigungsmaschine ferner konfiguriert sind zum: Erhalten (206), auf Basis des vierten Chipprodukts, eines Ziel-Chipprodukts, das den impedanzangepassten Josephson-Parameterverstärker umfasst.

## Revendications

1. Procédé de préparation d'une puce, le procédé comprenant :
la préparation (201), sur un substrat en utilisant un mode d'exposition par écriture laser directe, d'un premier circuit sous-jacent d'un amplificateur paramétrique Josephson à adaptation d'impédance, et la préparation, sur le substrat, d'un second circuit sous-jacent d'une jonction Josephson pour test, afin d'obtenir un premier produit puce ;
la génération (202), sur le premier produit puce en utilisant le mode d'exposition par écriture laser directe, d'une structure de résine photosensible pour préparer la jonction Josephson ;
la découpe (203) du premier circuit sous-jacent et du second circuit sous-jacent sur le premier produit puce, afin d'obtenir un deuxième produit puce comprenant le second circuit sous-jacent et un troisième produit puce comprenant le premier circuit sous-jacent ;
la production d'essai (204) d'un échantillon de jonction Josephson sur le deuxième produit puce en utilisant la structure de résine photosensible sur le second circuit sous-jacent, afin de déterminer une condition d'oxydation pour préparer une couche d'oxyde dans la jonction Josephson ;
la préparation (205), conformément à la condition d'oxydation, de la jonction Josephson sur le troisième produit puce en utilisant la structure de résine photosensible sur le premier circuit sous-jacent, afin d'obtenir un quatrième produit puce ; et
l'obtention (206), à partir du quatrième produit puce, d'un produit puce cible comprenant l'amplificateur paramétrique Josephson à adaptation d'impédance.

2. Procédé selon la revendication 1, dans lequel le premier circuit sous-jacent comprend une partie capacitance d'un résonateur LC inducteur-capaciteur non linéaire de l'amplificateur paramétrique Josephson à adaptation d'impédance ; et
la partie capacitance est une ligne de stub planaire d'une structure de guide d'ondes coplanaire.

3. Procédé selon la revendication 2, dans lequel l'obtention, à partir du quatrième produit puce, d'un produit puce cible comprenant l'amplificateur paramétrique Josephson à adaptation d'impédance comprend :
la préparation d'un pont aérien à une racine de la ligne de stub planaire sur le quatrième produit puce, afin d'obtenir le produit puce cible.

4. Procédé selon la revendication 3, dans lequel la préparation d'un pont aérien à une racine de la ligne de stub planaire sur le quatrième produit puce ; afin d'obtenir le produit puce cible comprend :
le revêtement d'une première couche de résine photosensible sur le quatrième produit puce ;
l'exposition et le développement d'une zone de pile de pont du pont aérien à une position de la première couche de résine photosensible correspondant à la racine de la ligne de stub planaire ;
la fusion à chaud de la première couche de résine photosensible, afin d'obtenir une première couche de résine photosensible cintrée ;
le dépôt d'un matériau de pont du pont aérien sur la première couche de résine photosensible cintrée ;
le revêtement d'une deuxième couche de résine photosensible sur le matériau de pont ;
l'exposition et le développement d'une zone à l'extérieur d'un pont du pont aérien dans la deuxième couche de résine photosensible ;
l'élimination du matériau de pont situé à l'extérieur du pont du pont aérien en utilisant un procédé de gravure ; et
le nettoyage d'une résine photosensible sur le quatrième produit puce, afin d'obtenir le produit puce cible.

5. Procédé selon la revendication 3, dans lequel, dans la condition d'oxydation, une valeur de résistance de l'échantillon de jonction Josephson est inférieure à une valeur de résistance de conception de la jonction Josephson, et une différence de valeur de résistance entre la valeur de résistance de l'échantillon de jonction Josephson et la valeur de résistance de conception de la jonction Josephson correspond à un incrément de valeur de résistance du pont aérien vers la jonction Josephson.

6. Procédé selon l'une quelconque des revendications 1 à 5, dans lequel la préparation, sur un substrat en utilisant un mode d'exposition par écriture laser directe, d'un premier circuit sous-jacent d'un amplificateur paramétrique Josephson à adaptation d'impédance, et la préparation, sur le substrat, d'un second circuit sous-jacent d'une jonction Josephson pour test, afin d'obtenir un premier produit puce comprend :
le dépôt d'un matériau de circuit sous-jacent sur le substrat ;
le revêtement d'une troisième couche de résine photosensible sur le matériau de circuit sous-jacent ;
l'exposition et le développement, dans la troisième couche de résine photosensible en utilisant le mode d'exposition par écriture laser directe, de zones de gravure correspondant au premier circuit sous-jacent et au second circuit sous-jacent ;
la gravure de la troisième couche de résine photosensible, afin d'éliminer le matériau de circuit sous-jacent dans les zones de gravure ; et
le nettoyage d'une résine photosensible du substrat, afin d'obtenir le premier produit puce.

7. Procédé selon la revendication 6, dans lequel l'exposition et le développement, dans la troisième couche de résine photosensible en utilisant le mode d'exposition par écriture laser directe, des zones de gravure correspondant au premier circuit sous-jacent et au second circuit sous-jacent comprend :
la définition, dans la troisième couche de résine photosensible en utilisant un mode d'écriture laser directe, des motifs de circuit du premier circuit sous-jacent et du second circuit sous-jacent ; et
le placement du substrat dans un révélateur pour développement, afin de développer les zones de gravure correspondant au premier circuit sous-jacent et au second circuit sous-jacent.

8. Procédé selon la revendication 7, dans lequel le premier circuit sous-jacent comprend un transformateur d'impédance de l'amplificateur paramétrique Josephson à adaptation d'impédance ; et
un biais de compensation existe entre une largeur de ligne du transformateur d'impédance dans une disposition et une largeur de ligne de conception du transformateur d'impédance, et le biais de compensation est déterminé sur la base d'un biais de gravure d'un traitement de gravure sur la troisième couche de résine photosensible.

9. Procédé selon l'une quelconque des revendications 1 à 8, dans lequel le second circuit sous-jacent comprend un réseau d'échantillons de jonctions Josephson, le réseau d'échantillons de jonctions Josephson comprend des circuits de ports d'au moins deux échantillons de jonctions Josephson, et chacun des circuits de ports correspond à un groupe de structures de résine photosensible ; et
la production d'essai d'un échantillon de jonction Josephson sur le deuxième produit puce en utilisant la structure de résine photosensible sur le second circuit sous-jacent, afin de déterminer une condition d'oxydation pour préparer une couche d'oxyde dans la jonction Josephson comprend :
la préparation, dans une première condition d'oxydation en utilisant la structure de résine photosensible sur un premier circuit de port, d'un échantillon de jonction Josephson correspondant au premier circuit de port, dans lequel le premier circuit de port est un circuit de port sur lequel un échantillon de jonction Josephson n'a pas été préparé dans les circuits de ports des au moins deux échantillons de jonctions Josephson ; et
la détermination, dans le cas où une première valeur de résistance satisfait une exigence de conception, de la première condition d'oxydation comme étant la condition d'oxydation pour préparer la couche d'oxyde dans la jonction Josephson, dans lequel la première valeur de résistance est obtenue, sur la base du premier circuit de port, par mesure de l'échantillon de jonction Josephson correspondant au premier circuit de port.

10. Procédé selon la revendication 9, dans lequel le procédé comprend en outre :
la mise à jour de la première condition d'oxydation et du premier circuit de port pour effectuer le test, dans le cas où la première valeur de résistance ne satisfait pas l'exigence de conception.

11. Procédé selon la revendication 9, dans lequel la structure de résine photosensible est une structure de pont Dolan, et la préparation, dans une première condition d'oxydation en utilisant la structure de résine photosensible sur un premier circuit de port, d'un échantillon de jonction Josephson correspondant au premier circuit de port comprend :
l'évaporation oblique, en utilisant la structure de résine photosensible sur le premier circuit de port, d'une première couche supraconductrice de l'échantillon de jonction Josephson correspondant au premier circuit de port ;
l'oxydation de la première couche supraconductrice dans la première condition d'oxydation, afin d'obtenir une couche isolante d'oxyde sur une surface de la première couche supraconductrice ; et
l'évaporation verticale, en utilisant la structure de résine photosensible sur le premier circuit de port, d'une deuxième couche supraconductrice de l'échantillon de jonction Josephson correspondant au premier circuit de port, afin d'obtenir l'échantillon de jonction Josephson correspondant au premier circuit de port.

12. Procédé selon la revendication 11, dans lequel la première condition d'oxydation comprend au moins l'un des éléments suivants :
un débit d'air d'un gaz oxygène,
une pression du gaz oxygène, et
une durée d'oxydation.

13. Système de préparation d'une puce, le système comprenant : une machine de revêtement de résine (1001), une machine de photogravure (1002), une machine d'évaporation (1004), une machine de gravure (1003), une chambre d'oxydation (1006), une machine de nettoyage (1005) et une machine de découpe (1007) ;
la machine de revêtement de résine, la machine de photogravure, la machine d'évaporation, la machine de gravure et la machine de nettoyage étant configurées pour : préparer (201), en utilisant un mode d'exposition par écriture laser directe, un premier circuit sous-jacent d'un amplificateur paramétrique Josephson à adaptation d'impédance sur un substrat, et préparer un second circuit sous-jacent d'une jonction Josephson pour test sur le substrat, afin d'obtenir un premier produit puce ;
la machine de revêtement de résine et la machine de photogravure étant configurées pour : générer (202), sur le premier produit puce en utilisant le mode d'exposition par écriture laser directe, une structure de résine photosensible pour préparer la jonction Josephson ;
la machine de découpe étant configurée pour découper (203) le premier circuit sous-jacent et le second circuit sous-jacent sur le premier produit puce, afin d'obtenir un deuxième produit puce comprenant le second circuit sous-jacent et un troisième produit puce comprenant le premier circuit sous-jacent ;
la machine d'évaporation et la chambre d'oxydation étant configurées pour produire en essai (204) un échantillon de jonction Josephson sur le deuxième produit puce en utilisant la structure de résine photosensible sur le second circuit sous-jacent, afin de déterminer une condition d'oxydation pour préparer une couche d'oxyde dans la jonction Josephson ;
la machine d'évaporation et la chambre d'oxydation étant en outre configurées pour : préparer (205), conformément à la condition d'oxydation, la jonction Josephson sur le troisième produit puce en utilisant la structure de résine photosensible sur le premier circuit sous-jacent, afin d'obtenir un quatrième produit puce ; et
la machine de revêtement de résine, la machine de photogravure, la machine d'évaporation, la machine de gravure et la machine de nettoyage étant en outre configurées pour : obtenir (206), à partir du quatrième produit puce, un produit puce cible comprenant l'amplificateur paramétrique Josephson à adaptation d'impédance.
